(19) **Europäisches Patentamt**

**European Patent Office**

**Office européen des brevets**

(11) **EP 1 065 669 A2**

(12) **EUROPEAN PATENT APPLICATION**

(43) Date of publication:
03.01.2001 Bulletin 2001/01

(51) Int. Cl.⁷: **G11C 16/10**

(21) Application number: **00302873.5**

(22) Date of filing: **05.04.2000**

(84) Designated Contracting States:
**AT BE CH CY DE DK ES FI FR GB GR IE IT LI LU
MC NL PT SE**
Designated Extension States:
**AL LT LV MK RO SI**

(30) Priority: **22.06.1999 KR 9923533**

(71) Applicant:
**Samsung Electronics Co., Ltd.
Suwon, Kyungi-do (KR)**

(72) Inventors:
• **Lee, Byeong-Hoon
  Seoul (KR)**
• **Lim, Young-Ho
  Suwon, Kyunggi-do (KR)**

(74) Representative:
**Mounteney, Simon James
MARKS & CLERK,
57-60 Lincoln's Inn Fields
London WC2A 3LS (GB)**

(54) **High-density NOR-type flash memory device and programming method therefor**

(57) A flash memory device and a programming method for use in a flash memory device are disclosed. According to the programming method, first, one of data bits to be programmed starts to be programmed in a corresponding memory cell. Then, before the previous program operation is ended, the next of the data bits starts to be programmed. By such a program algorithm, although the integration degree of the flash memory device is increased, a sufficient amount of current required to program can be supplied without an increment of the size of the integrated circuit die due to the charge pump circuit.

**Fig. 5**

**EP 1 065 669 A2**

**Description**

Field of the Invention

The present invention relates to a flash memory device, and more particularly to a high-density NOR-type flash memory device which operates at very low power supply voltage, and to a method of programming the memory device.

Background of the Invention

Flash memories are commonly employed in a wide variety of computer systems to provide nonvolatile information storage. Conventional flash memories typically include program circuitry for programming information into the flash memory cells as well as erase circuitry for erasing the memory cells. However, the voltage levels required by such program and erase circuitry differ from the power supply voltage levels that are typically available from a computer system power supply voltage.

Some flash memories require multiple voltage supplies to accommodate the program and erase circuitry. For example, any flash memory requires a power supply voltage and a separate high voltage for the program circuitry. Unfortunately, such a requirement of dual voltage supplies typically increases the complexity of power system design for computer systems that employ such dual supply flash memories and increases the overall cost of such systems.

On the other hand, single power supply flash memories commonly contain specialized circuitry that generates the appropriate voltage levels and electrical current levels required to program and erase the individual flash memory cells. For example, such flash memories typically include charge pump circuitry that converts a single electrical supply voltage into the appropriate voltage level required to drive the inputs to the flash memory cells during programming.

More recent computer systems, such as portable computers, employ integrated circuits and other devices that function with relatively low power supply voltage levels in comparison to earlier systems. For example, conventional notebook computer systems that employed 5V power supply voltage are now evolving toward 3V or lower power supply voltages (for example, 2V or 1.5V).

Unfortunately, such low levels of electrical power supply voltages impose a practical limit on the amount of electrical programming current that can be generated by charge pump circuitry on the flash memory. Such a limit on available programming current may reduce the overall speed of such flash memories by limiting the number of flash cells that can be programmed simultaneously.

Theoretically, a larger and more complex implementation of charge pump circuitry would provide the necessary electrical current required to program entire bytes or words of flash memory cells simultaneously. If the voltage level of the power supply voltage is more reduced, for example, it is lowered below 2V, the charge pump circuitry becomes much more complicated and much larger. This makes such larger and more complex charge pump circuitry consume large areas of an integrated circuit die. Such large amounts of integrated circuit die space dedicated to charge pump typically reduces the available for flash memory cells and associated access circuitry which thereby limits the overall storage capacity of such a flash memory. On the other hand, such large amounts of die space may require a significant increase in the overall size of the integrated circuit die which increases manufacturing costs.

Summary of the Invention

It is therefore an object of the present invention to provide a high-density NOR-type flash memory device capable of reducing the size of charge pump by minimizing maximum operating current consumed during programming, and to provide its programming method.

It is another object of the invention to provide a high-density NOR-type flash memory device which can shorten program time, and to provide its programming method.

In order to attain the above objects, according to an aspect of the present invention, there is provided a program method of a NOR-type flash memory device. According to the program method, at least two ones of memory cells provided in the memory device are selected by a row and a column selecting circuit. And then, the selected memory cells are sequentially programmed by means which comprises a pump circuit, a write driver, a select circuit, and a program period control circuit. In this embodiment, after one of the selected memory cells starts to be programmed and a first time elapses, the other one of the selected memory cells starts to be programmed. The first time corresponds to a time required to program the respective selected memory cells up to a predetermined threshold voltage below a target threshold voltage, and is set shorter in time than a second time required to program the respective selected memory cells up to the target threshold voltage.

Brief Description of the Drawings

The present invention will be described by way of exemplary embodiments, but not limitations, illustrated in the accompanying drawings in which like references denote similar elements, and in which:

Fig. 1 is a cross-sectional diagram showing a conventional flash memory cell;

Fig. 2 is a diagram showing a relationship between cell current and program time when two data bits are simultaneously programmed;

Fig. 3 is a diagram showing a relationship between a threshold voltage of a flash memory cell and program time during programming;

Fig. 4 is a diagram showing variations of a threshold voltage and cell current according to program time;

Fig. 5 is a block diagram showing a flash memory device according to a preferred embodiment of the present invention; and

Fig. 6 is a diagram showing a relationship between cell current and program time according to the program method of the present invention.

Description of the Preferred Embodiment

Hereinafter, the preferred embodiment according to the present invention will be more fully described with reference to the accompanying drawings.

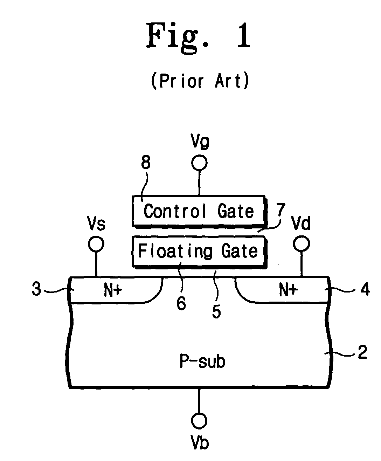

Referring to Fig. 1 which shows a cross-sectional diagram of a flash memory cell, the flash memory cell has $N^+$-type source 3 and drain 4 formed in a P-type substrate 2, a floating gate 6 formed over a channel with a thin insulating layer 5 below 100Å interposed therebetween, and a control gate 8 formed over the floating gate 6 with another insulting layer 7 interposed therebetween.

The flash memory cell in Fig. 1 is programmed by grounding the substrate 2 and the source region 3, applying a high voltage Vg of about + 10V to the control gate 8 and a positive voltage Vd of about +5V~+6V to the drain 4. If a predetermined time elapses under this bias condition, a sufficient amount of negative charges are injected to the floating gate 6 from the channel adjacent to the drain 4. At this time, the floating gate 6 has (-) potential. This functions to increase a threshold voltage of the flash memory cell during a read operation. Such a state of flash memory cell is named "off cell". When the positive voltage Vd of about +5V~+6V is applied to the drain 4 of the off cell , no cell current to the grounded source 3 from the drain 4 flows. An erased state, that is, an un-programmed state of flash memory cell is named "on cell". When the positive voltage Vd of about +5V~+6V is applied to the drain 4 of the on cell, cell current of about 200μA flows to the source 3 from the drain 4 through the channel.

As well known to ones skilled in the art, selected memory cells of a flash memory device, such as NOR-type flash memory device, are programmed by the byte unit (composed of 8 data bits) or the word unit (composed of 16 data bits). When all data bits of the byte/word unit are simultaneously programmed, the maximum current of 1.6mA (200μA*8) is required when programmed by the byte unit, and the maximum current of 3.2mA (200μA*16) is required when programmed by the word unit. A very large charge pump is required in order to generate the voltage Vd of about +5V~+6V to be supplied to the drain 4 of the flash memory cell and simultaneously to supply the much amount of current (that is, 1.6mA or 3.2mA). This, as set fourth above, makes such a charge pump consume large areas of an integrated circuit die. Such large amounts of integrated circuit die space dedicated to charge pump typically reduces the available for flash memory cells and associated access circuitry to thereby limit the overall storage capacity of such a flash memory (it means that a size of the integrated circuit die is increased). Furthermore, when a much amount of current is instantly consumed, power noise is occurred, thereby causing a malfunction of the flash memory device, as will be more fully described below. As the power supply voltage level used in the NOR-type flash memory device is lowered more and more, such a problem may become more serious.

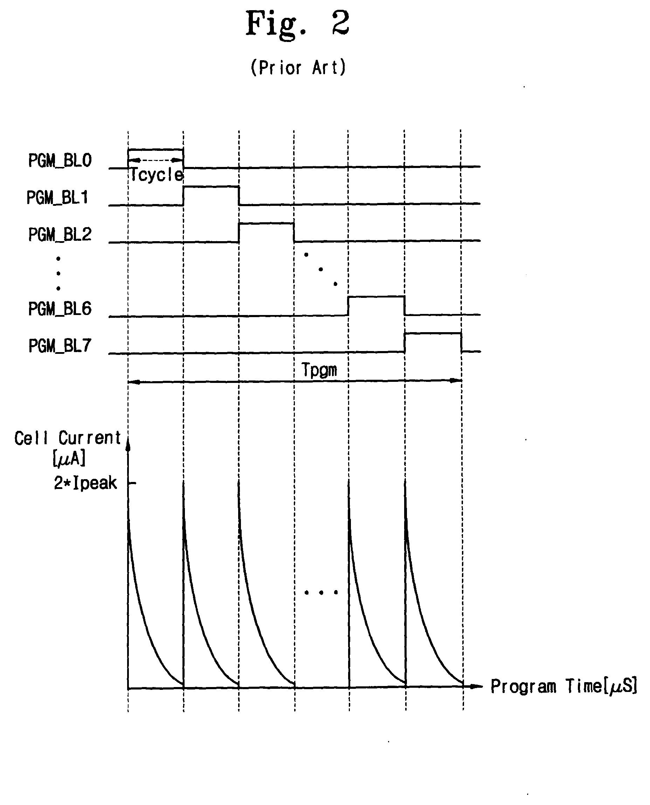

According to a conventional program method for reducing the area dedicated for the charge pump, first, a plurality of data bits to be programmed are divided into plural groups. And then, data bits of each of the plural groups are simultaneously programmed in unit program time Tcycle (it corresponds to a time required to program sufficiently up to a target threshold voltage of a flash memory cell). For example, in the case where each group is composed of two data bits, as shown in Fig. 2, maximum current consumed in the unit program time Tcycle is reduced by 1/8, that is, about 400μA, as compared with the above-described program method (such a method that all of the data bits of word unit are simultaneously programmed). Therefore, the size of charge pump may be decreased in proportion to the maximum current thus reduced. Herein, assuming that peak current of a flash memory cell is symbolized by Ipeak, as illustrated in Fig. 2, the maximum current of the respective unit program time Tcycle corresponds to twice the peak current (2Ipeak). On the other hand, it can be seen that total program time Tpgm becomes eight times longer than the above-described program method (when Tcycle=1μs, Tpgm=1μs*8=8μs).

In the case that the NOR-type flash memory device operates at a very low power supply voltage (for example, below 2.0V), a time may become longer which is required to generate current level and voltage level to be supplied to the drain of the flash memory cell during programming. On the other hand, in order to reduce the total program time, the size of charge pump may be increased. In this case, the charge pump consumes a large area of the integrated circuit die when the flash memory device is integrated high. It means that such large amounts of integrated circuit die space dedicated to charge pump typically reduces the available for flash memory cells and associated access circuitry, thereby limiting the overall storage capacity of such a flash memory.

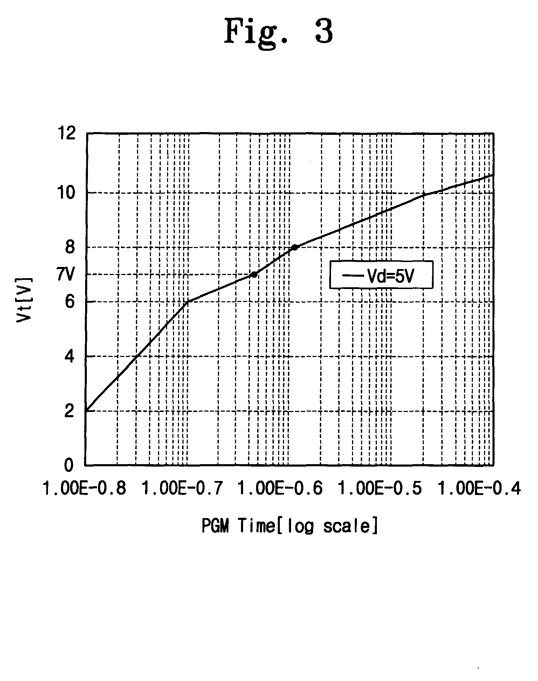

Referring to Fig. 3, a diagram of showing the relationship of program time and a cell's threshold voltage is illustrated. In Fig. 3, a vertical axis indicates a threshold voltage of a flash memory cell, and a horizontal axis indicates program time thereof which is illustrated by a log scale. Assume that a target threshold voltage Vth_pgm of the cell to be programmed is 8V, and that the unit program time Tcycle required to program the cell is 1µs. Under this condition, it can be seen from Fig. 3 that the threshold voltage Vth of the cell is increased up to about 7V (approximately 85%) in 0.5µs which is half of the unit program time Tcycle.

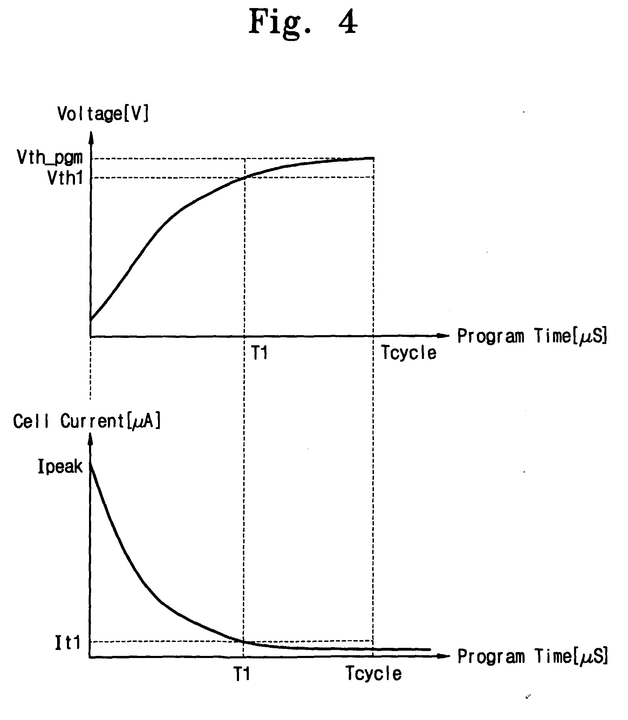

As illustrated in Fig. 4 which shows variations of the threshold voltage and the cell current depending on the program time, the threshold voltage Vth of the cell is sharply increased up to Vth1 during a time 0~T1, while the cell current flowing through the programmed cell is sharply decreased (consumed) from Ipeak to It1 during the first program time. And then, during a time T1~Tcycle, the threshold voltage Vth of the cell is slowly increased from Vth1 to Vth_pgm, and few amount of cell current is consumed.

As seen from Figs. 3 and 4, when the threshold voltage Vth of the flash memory cell is sharply increased at the incipient stage of the unit program time Tcycle, the cell current which flows from the drain to the source via the channel, is sharply decreased. Herein, it is obvious to ones skilled in the art that such a slope that the threshold voltage Vth is increased depending on the characteristic of the flash memory cell, can be varied. It means that the time 0~T1 either becomes shorter or longer depending on the characteristic of the cell.

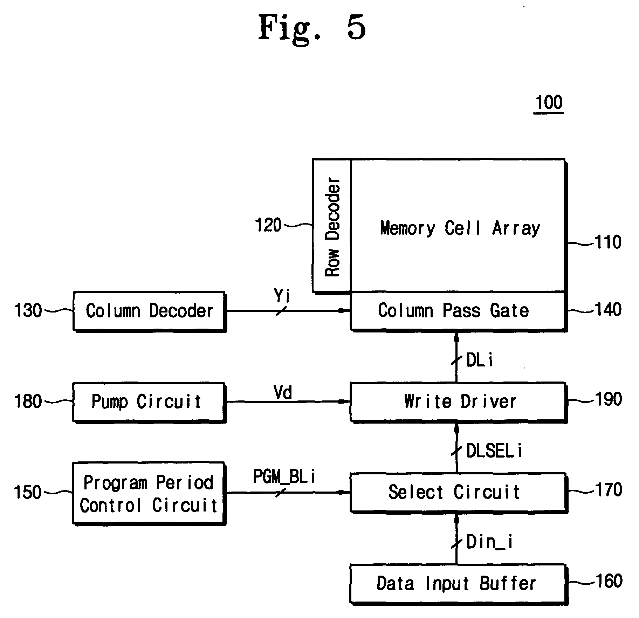

A block diagram showing the NOR-type flash memory device according to the preferred embodiment is illustrated in Fig. 5. The NOR-type flash memory device 100 comprises a memory cell array 110, which is composed of, although not shown in figure, plural word lines extending along rows, plural bit lines extending along columns and plural flash memory cells (or EEPROM cells) each arranged at intersections of the word lines and the bit lines. One of the word lines is selected by a row decoder circuit 120 depending on a row address, and a part of the bit lines are selected by a column decoder circuit 130 and a column pass gate circuit 140 depending on a column address. For example, in the case where memory cells are programmed by the byte unit, 8 bit lines are selected by the column decoder circuit 130 and the column pass gate circuit 140. And, in the case where memory cells are programmed by the word unit, 16 bit lines are selected by the column decoder circuit 130 and the column pass gate circuit 140. That is, 8/16 flash memory cells are selected which are arranged at intersections of the selected word line and the selected bit lines, respectively.

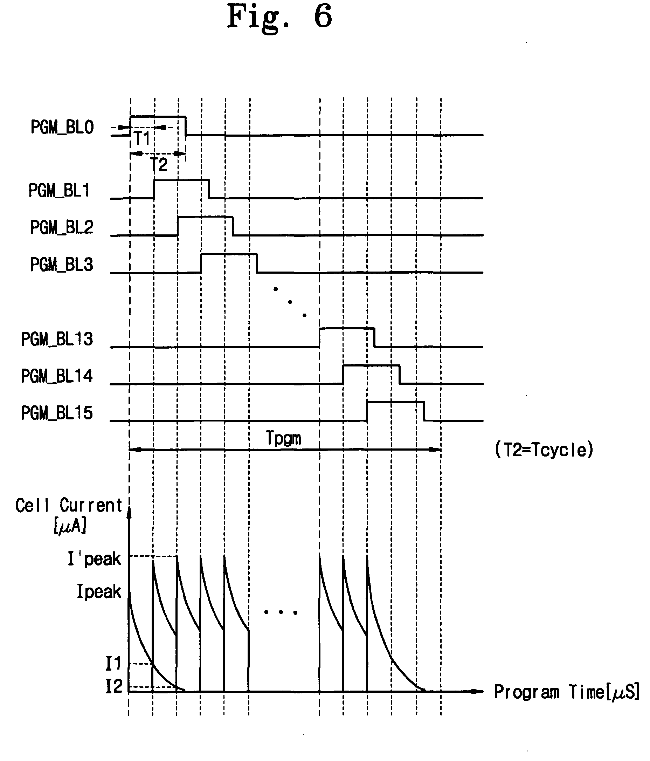

In the flash memory device 100, a program period control circuit 150, a data input buffer circuit 160, a select circuit 170, a pump circuit 180 and a write driver circuit 190 are further provided. Data bits of '0' or '1' to be programmed are temporally stored in the data input buffer circuit 160 according to the byte/word unit. The program period control circuit 150 generates program period signals PGM_BLi of a pulse form when a program operation for the selected memory cells is performed. The program period signals PGM_BLi are generated such that activation periods of adjoining program period signals are overlapped to each other, as illustrated in Fig. 6 and as will be more fully described below. And, the program period signals PGM_BLi correspond to data bits Din_i (i=0~15) to be programmed, respectively. In this embodiment, the program period control circuit 150, for example, comprises a counter.

Continuously, the select circuit 170 receives the program period signals PGM_BLi (i=0~17) thus generated and the data bits Din_i (i=0~15), and then produces data line select signals DLSELi (i=0-15) which correspond to the selected bit lines, respectively. For example, when the program period signal PGM_BL0 is activated and the data bit Din_0 is to be programmed (for example, logic '0'), the data line select signal DLSEL0 is activated. On the other hand, when the program period signal PGM_BL0 is activated and the data bit Din_0 is to be program-inhibited (for example, logic '1'), the data line select signal DLSEL0 is inactivated. Other data line select signals DLSEL1 to DLSEL15 are activated or inactivated according to the above-described manner.

The pump circuit 180 provides the write driver circuit 190 with a drain voltage Vd (for example, 5V) and a current to be transferred to the selected bit line(s). The write driver circuit 190 supplies the selected bit lines with the drain voltage Vd and the current from the pump circuit 180 in response to the data line select signals DLSELi. Similarly to the program period signals, activation periods of adjoining ones among the select signals DLSELi are also overlapped to each other. As a result, program periods of the selected memory cells are overlapped.

An example of the pump circuit 180 is disclosed in U.S. Patent No. 5,642,309 entitled *"AUTO-PROGRAM CIRCUIT IN A NONVOLATILE SEMICONDUCTOR MEMORY DEVICE"*, which is hereby incorporated by reference.

Assuming that the cells of the above-described NOR-type flash memory device 100 are programmed by the word unit, the program operation of the present invention will be more fully described below. However, it is obvious that the program method of the present invention can be applied to a flash memory device which is programmed depending on the byte unit. And the NOR-type flash memory device 100 supports read-while-write (RWW) mode of operation in which a program operation and a read operation are simultaneously performed. The memory device of the RWW mode of operation is disclosed in U.S. Patent No. 5,867,430 entitled *"BANK ARCHITECTURE FOR A NON-VOLATILE MEMORY ENABLING SIMULTANEOUS READING AND WRITING"*, which is hereby incorporated by reference.

Fig. 6 is a diagram showing the relationship between cell current and program time according to the program method of the preferred embodiment of the present invention. Prior to describing the program method of the present invention, the first program time T1 is defined as a time when the threshold voltage Vth of the flash memory cell reaches a threshold voltage (for example, 6V~7V) Vth1 below the target threshold voltage Vth_pgm, and a second program time T2 is defined as a time which is required to program the flash memory cell sufficiently up to the target threshold voltage Vth_pgm. Herein, the second time T2 corresponds to the unit program time Tcycle for a flash memory cell. The threshold voltage below the target threshold voltage Vth_pgm may be set considering the relationship between the size of the charge pump circuit and the peak current.

When the program operation starts, one of the word lines of the memory cell array 110 is selected by the row decoder circuit 120, and 16 bit lines (of the word unit) are selected by the column decoder circuit 130 and the column pass gate circuit 140. As a result of the above-described operation, 16 flash memory cells are selected which are arranged at intersections of the selected word line and the selected bit lines, respectively. Although not shown in figure, a high voltage of about 10V which, for example, is pumped from a well-known word line voltage generating circuit, may be supplied to the selected word line, to which control gates of the selected cells are commonly coupled.

And then, when a first program period signal PGM_BL0 is activated high by means of the program period control circuit 150, the select circuit 170 receives the first program period signal PGM_BL0 and a first data bit Din_0 (for example, logic '0'), and then activates a first data line select signal DLSEL0 in response thereto. The first data bit Din_0 is one of the data bits Din_0 to Din_15 which are stored in the data input buffer circuit 160 and are to be programmed. This forces the drain voltage Vd and the current from the pump circuit 180 to be supplied to a first bit line corresponding to the first data bit Din_0 (or first data line select signal DLSEL0) through the write driver circuit 190 and the column pass gate circuit 140. Accordingly, a first flash memory cell coupled to the first bit line starts to be programmed. At this time, as set forth above, the cell current flowing via the first selected flash memory cell corresponds to the maximum current Ipeak of about 200μA.

After first program time T1 for the first flash memory cell elapses, as illustrated in Fig. 6, a second program period signal PGM_BL0 is activated high while the first program period signal PGM_BL0 is activated (that is, before the program operation for the first flash memory cell is ended). Successively, the select circuit 170 receives the second program period signal PGM_BL1 and a second data bit Din_1 (for example, logic '0'), and then activates a second data line select signal DLSEL1 in response thereto. The drain voltage Vd and the current from the pump circuit 180 are supplied to a second bit line corresponding to the second data bit Din_1 through the write driver circuit 190 and the column pass gate circuit 140. Therefore, a second flash memory cell coupled to the second bit line starts to be programmed.

As seen from the above-description and Fig. 6, since activation periods of the data line select signals DLSEL0 and DLSEL1 (or program period signals PGM_BL0 and PGM_BL1), the first and second cells are simultaneously programmed. At this time, the maximum current consumed when the second cell is programmed, corresponds to a sum of the current I1 flowing via the first cell and the current Ipeak flowing via the second cell at the point of time when the first program time T1 for the first cell elapses.

Continuously, as illustrated in Fig. 6, after first program time T1 for the second flash memory cell elapses, a third program period signal PGM_BL2 is activated high while the first and second program period signals PGM_BL0 and PGM_BL1 are activated. This is because the first program time T1 is set shorter in time than half the second program time T2. And then, a third flash memory cell starts to be programmed in the same manner as described above. Therefore, the first, second and third memory cells are simultaneously programmed. At the point of time when the first program time T1 for the second memory cell elapses, the maximum current consumed when the third memory cell is programmed, corresponds to a sum of the current I2 flowing via the first cell, the current I1 flowing via the second cell, and the current Ipeak flowing via the third cell. Other data bits Din_3~Din_15 stored in the data input buffer circuit 160 are sequentially programmed in the same manner as mentioned above.

Herein, the program operation for each of the flash memory cells associated with the data bits is automatically ended after the second program time T2 therefor elapses.

According to the program method of the first embodiment, a total program time Tpgm is as follows.

$$T_{pgm} = T1 \times N + (T2 - T1)$$

Herein, the symbol N indicates the number of data bits to be programmed (N=8 in the case of the byte unit, N=16 in the case of the word unit). For example, when N=16, T2=1μs, and T1=0.5μs, the total program time Tpgm of the word unit is 8.5μs (0.5μs*16+0.5μs). And, when N=8, T2=1μs, and T1=0.5μs, the total program time Tpgm of the byte unit is 4.5μs (0.5μs*8+0.5μs). As seen from the above description and from Fig. 6, the maximum current consumed in the unit program time Tpgm is I'peak (Ipeak+I1+I2), which is less than that of the conventional program method (two data bits are simultaneously programmed up to the target threshold voltage).

That is, the maximum current at programming is reduced as compared with the conventional program method.

Therefore, according to the preferred embodiment of the invention, although the integration degree of the NOR-type flash memory device is increased and the power supply voltage level used in the memory device is lowered (for example, below 2.0V), a sufficient amount of current required to program can be supplied without an increment of the size of the integrated circuit die due to the pump circuit 180.

If T1<0.5*T2 and N=16, the total program time Tpgm may be reduced, while the maximum current consumed in the unit program time Tcycle may be increased a little.

The program method of the present invention has been described under the condition that the first program time T1 is shorter than half the second program time T2 (that is, the unit program time). However, the number of data bits to be simultaneously programmed during the second program time T2 may be determined depending on the relationship of the first and second program time T1 and T2. For example, when T1=0.5*T2 , the number of data bits to be simultaneously programmed during the second program time T2 is 2. And, when Ti<0.5*T2 , the number of data bits to be simultaneously programmed during the second program time T2 is 3 or more.

It can be seen from the above-described program algorithm that the maximum current consumed during the program operation of the embodiment is less than that of the conventional program method. Therefore, the size of the pump circuit 180 to be designed according to the program method of the preferred embodiment is considerably reduced as compared with the conventional method of programming two data bits at the same time. Accordingly, according to the preferred embodiment of the invention, although the integration degree of the NOR-type flash memory device is increased and the power supply voltage level used in the memory device is lowered (for example, below 2.0V), a sufficient amount of current required to program can be supplied without an increment of the size of the integrated circuit die due to the pump circuit 180.

Furthermore, as set forth above, Since the NOR-type flash memory device has the RWW mode of operation, the program operation for one bank is performed, and the read operation for another bank is performed. It is obvious to ones skilled in the art that power noise is caused when the high voltage Vd and the drain current are generated from the pump circuit. The power noise caused during the programming affects the read operation which is performed in the another bank. Therefore, it is desirable that the maximum value of drain current causing the power noise is less. As a result, since a maximum current caused when the program operation is performed is decentralized, it can be minimized.

The invention has been described using an exemplary preferred embodiment. However, it is to be understood that the scope of the invention is not limited to the disclosed embodiment. On the contrary, it is intended to cover various modifications and similar arrangements. The scope of the claims, therefore, should be accorded the broadest interpretation so as to encompass all such modifications and similar arrangements.

**Claims**

1. A program method for use in a flash memory device having an array of memory cells arranged in rows and columns, comprising the steps of:

   selecting at least two ones of the memory cells; and
   sequentially programming the selected memory cells such that program periods for the selected memory cells are overlapped.

2. The method according to claim 1, wherein after one of the selected memory cells starts to be programmed and a first time elapses, the other one of the selected memory cells starts to be programmed.

3. The method according to claim 2, wherein the first time corresponds to a time required to program the respective selected memory cells up to a predetermined threshold voltage below a target threshold voltage.

4. The method according to claim 3, wherein the first time is set shorter in time than a second time required to program the respective selected memory cells up to the target threshold voltage.

5. The method according to claim 1, wherein the flash memory device comprises a NOR-type flash memory device.

6. A program method for use in a NOR-type flash memory device having an array of memory cells arranged in rows and columns, comprising the steps of:

   selecting plural ones of the memory cells; and
   sequentially programming the selected memory cells,
   wherein a first time required to program the respective selected memory cells up to a predetermined threshold voltage below a target threshold voltage is set shorter in time than a second time required to program the respective selected memory cells up to the target threshold voltage.

**7.** A program method for use in a NOR-type flash memory device having an array of memory cells arranged in rows and columns, comprising the steps of:

> selecting plural ones of the memory cells;
> performing a program operation for one of the selected memory cells; and
> performing, before the previous program operation is completed, a program operation for the next of the selected memory cells.

**8.** A NOR-type flash memory device comprising:

> an array of a plurality of memory cells arranged in rows and columns;
> a row selecting circuit for selecting one of the rows;
> a column selecting circuit for selecting ones of a group among the columns;
> a pump circuit for generating a drain voltage to be supplied to the selected columns during a program operation;
> a program period control circuit for sequentially generating program period signals indicating a program period of memory cells assigned by the selected row and columns;
> a select circuit for generating select signals assigning the selected columns respectively in response to the program period signals and data bits to be programmed to the assigned memory cells; and
> a write driver circuit for driving the selected columns with the drain voltage from the pump circuit in response to the select signals,
> wherein the program period control circuit generates the program period signals so that program periods for the assigned memory cells are overlapped.

**9.** The memory device according to claim 8, wherein after one of the assigned memory cells starts to be programmed and a first time elapses, the next one of the assigned memory cells starts to be programmed.

**10.** The memory device according to claim 9, wherein the first time corresponds to a time required to program the respective assigned memory cells up to a predetermined threshold voltage below a target threshold voltage.

**11.** The memory device according to claim 10, wherein the first time is set shorter in time than a second time required to program the respective assigned memory cells up to the target threshold voltage.

**12.** The memory device according to claim 8, wherein the flash memory device comprises a NOR-type flash memory device.

**13.** The memory device according to claim 8, wherein the program period control circuit comprises a counter.

# Fig. 1

(Prior Art)

# Fig. 2

(Prior Art)

# Fig. 3

# Fig. 4

# Fig. 5

# Fig. 6